# EUROPÄISCHE PATENTANMELDUNG

(11) **EP 3 796 397 A1**
(43) Veröffentlichungstag der Anmeldung: **24.03.2021**
(21) Anmeldenummer: 20195442.7
(22) Anmeldetag: 10.09.2020
(51) Int. Cl.: H01L 31/048

(54) **PHOTOVOLTAIKELEMENT**

(30) Priorität: 18.09.2019 AT 508082019
(71) Anmelder: Lenzing Plastics GmbH & Co KG, 4860 Lenzing (AT)
(72) Erfinder: Brandstätter, Andreas, 4851 Gampern (AT)
(74) Vertreter: Fabian, Ferdinand

(57) **Zusammenfassung**

Die Erfindung betrifft ein Photovoltaikelement (1) umfassend ein oberes Einbettfolienmaterial (2) und ein unteres Einbettfolienmaterial (5), wobei zwischen dem oberen und dem unteren Einbettfolienmaterial (2, 5) Photovoltaikzellen (4) eingebettet sind, und das obere Einbettfolienmaterial (2) durch ein Verbundmaterial gebildet ist, das eine Kunststoffschicht (7) und transparente Fasern umfasst, wobei die transparenten Fasern eine eigene Faserschicht (8) bilden, die einen Anteil an dem Kunststoff der Kunststoffschicht (7) von maximal 10 Gew.-% aufweist.

## Beschreibung

Die Erfindung betrifft ein Photovoltaikelement umfassend ein oberes Einbettfolienmaterial und ein unteres Einbettfolienmaterial, wobei zwischen dem oberen und dem unteren Einbettfolienmaterial Photovoltaikzellen eingebettet sind, und das obere Einbettfolienmaterial durch ein Verbundmaterial gebildet ist, das eine Kunststoffschicht und transparente Fasern umfasst.

Ein handelsübliches Photovoltaikmodul besteht an der Vorderseite (der der Sonne zugewandten Seite) aus einer Glasscheibe, einer darunter liegenden transparenten Einbettfolie, um die PV-Zellen und deren elektrische Verdrahtung (Lötbändchen) zum Glas hin einzubetten. Unterhalb der Elektronik mit den PV-Zellen befindet sich typischerweise wieder eine Einbettfolie und den rückseitigen Abschluss bildet ein Folienlaminat, die sogenannte Rückseitenfolie, die beispielsweise aus einem PVF-PET-PVF-Laminat (Polyvinylfluorid-Polyethylenterephthalat-Polyvinylfluorid-Laminat) gebildet ist. Die Einbettfolien sind typischerweise aus EVA (Polyethylen-Vinylacetat) aufgebaut. Alle Schichten werden beim Zusammenbau der Module übereinandergelegt und miteinander thermisch laminiert. Das EVA wird chemisch vernetzt. Beim Laminieren bildet sich aus der bis dahin milchigen EVA-Folie eine klare, dreidimensional vernetzte und nicht mehr aufschmelzbare Kunststoffschicht, in der die PV-Zellen eingebettet sind und die fest mit der Glasscheibe und der Rückseitenfolie verbunden ist.

Es gibt aber auch flexible Photovoltaikelemente bei denen die Glasscheibe durch ein Polymermaterial ersetzt ist. Beispielsweise zeigt die EP 2 863 443 A1 ein Photovoltaik-Paneel mit zumindest einer Solarzelle, welche zumindest an ihrer dem Licht zugewandten Seite und ihrer gegenüberliegenden, dem Licht abgewandten Seite mit einem transparenten Verbundmaterial bedeckt ist, das ein mit Glasfasern verstärkter Kunststoff auf Basis eines Acrylats enthaltend Epoxigruppen ist. Auf der lichtzugewandten Seite sind die Solarzellen in eine Schicht aus EVA (Ethylenvinylacetat) eingebettet. Es wird damit nicht nur ein möglichst flexibles Paneel zur Verfügung gestellt, sondern weist dieses auch ein relativ geringes Gewicht auf.

Der vorliegenden Erfindung liegt die Aufgabe zugrunde, ein Photovoltaikelement hinsichtlich seiner Eigenschaft als Gebäudeintegriertes Element (BIPV) zu verbessern.

Diese Aufgabe wird bei dem eingangs genannten Photovoltaikelement dadurch gelöst, dass die transparenten Fasern eine eigene Faserschicht bilden, die einen Anteil an dem Kunststoff der Kunststoffschicht von maximal 10 Gew.-% aufweist.

Von Vorteil ist dabei, dass durch die Faserschicht an sich die Photovoltaikzellen nach außen hin abgedeckt werden können, womit das äußere Erscheinungsbild des Photovoltaikelementes verändert werden kann, da die Photovoltaikzellen nicht mehr sichtbar sind bzw. in der Durchsicht durch die Faserschicht ein anderes Aussehen aufweisen. Durch diese Veränderung kann das Photovoltaikelement besser in eine Gebäudefassade oder in ein Gebäudeelement integriert werden. Durch die Vermeidung der Durchdringung der Faserschicht mit dem Kunststoff der Kunststoffschicht, können die optischen Eigenschaften der Faserschicht nicht bzw. im Verbund mit der Kunststoffschicht nur geringfügig verändert erhalten bleiben. Es kann damit ein der Sonne zugewandtes oberes Einbettfolienmaterial zur Verfügung gestellt werden, das trotz der Abdeckung der Photovoltaikzellen eine relative hohe Transmission für Sonnenlicht aufweist.

Nach einer Ausführungsvariante des Photovoltaikelementes kann vorgesehen sein, dass der Kunststoff der Kunststoffschicht bis zu einer Dicke der Faserschicht enthalten ist, die maximal 20 % der Gesamtdicke der Faserschicht beträgt. Es können damit die voranstehend genannten verbessert werden, wobei gleichzeitig bei einem geringfügigen Eindringen des Kunststoffes der Kunststoffschicht in die Faserschicht die Anbindung der Kunststoffschicht an die Faserschicht verbessert werden kann.

Bevorzugt besteht die Kunststoffschicht aus einem Polyethylenterephthalat und/oder einem Ethylen-Tetrafluorethylen-Copolymer, da sich bei der Evaluierung der Erfindung mit einem derartigen Kunststoff die Transmission des Sonnenlichts durch die Faserschicht nur relativ wenig reduziert wird. Es kann damit also ein relativ hoher Wirkungsgrad des Photovoltaikelementes erreicht werden.

Nach einer weiteren Ausführungsvariante des Photovoltaikelementes kann vorgesehen sein, dass auf der, der Faserschicht abgewandten Seite der Kunststoffschicht eine weitere Kunststoffschicht angeordnet ist, die gegen UV-Strahlen stabiler ist, als die darunter angeordnete Kunststoffschicht. Durch diese Verbesserung der Stabilität des oberen Einbettfolienmaterials kann auf eine weitere, der Sonne zugewandte Abdeckung des Photovoltaikelementes verzichtet werden, womit sich der Aufbau des Photovoltaikelementes vereinfachen lässt, da der mechanische Schutz der Photovoltaikelemente gegen Umwelteinflüsse bereits durch die Faserschicht erreicht werden kann. Es ist damit also ein Aufbau des Photovoltaikelementes mit geringerem Gewicht möglich, mit wiederum die Integration des Photovoltaikelementes in eine Gebäudehülle verbessert bzw. vereinfacht werden kann.

Dabei kann gemäß einer weiteren Ausführungsvariante des Photovoltaikelementes vorgesehen sein, dass die weitere Kunststoffschicht das Polymer der ersten Kunststoffschicht aufweist, womit die Verbindung zwischen den beiden Kunststoffschichten verbessert werden kann.

Nach einer anderen Ausführungsvariante des Photovoltaikelementes kann auch vorgesehen sein, dass die weitere Kunststoffschicht eine Schichtdicke aufweist, die zwischen 10 % und 50 % der Schichtdicke der darunter angeordneten Kunststoffschicht entspricht. Die weitere Kunststoffschicht kann also (deutlich) dünner ausgeführt sein, als die darunter angeordnete Kunststoffschicht, womit wiederum Gewicht eingespart werden kann und auch einer Delamination besser vorgebeugt werden kann.

Eine weitere Vereinfachung des Aufbaus des Photovoltaikelementes kann auch erreicht werden, wenn gemäß einer weiteren Ausführungsvariante die Faserschicht direkt an den Photovoltaikzellen anliegt. Es ist damit durch eine fehlende Anbindung bzw. Anlage der Faserschicht an die/den Photovoltaikzellen eine bessere Beweglichkeit der Faserschicht relativ zu den Photovoltaikzellen erreichbar, womit das Photovoltaikelement Temperaturwechselbelastungen besser standhalten kann.

Nach einer weiteren Ausführungsvariante des Photovoltaikelementes kann vorgesehen sein, dass die Faserschicht ein Flächengewicht von mindestens 100 g/m² und maximal 150 g/m² aufweist. Es sind damit relativ hohe Lichtausbeuten der Photovoltaikzellen erreichbar, da mit einem Gewebe dieses Flächengewichts Werte für die Transmission von deutlich mehr als 50 % erhalten werden können.

Von Vorteil kann weiter sein, wenn nach einer anderen Ausführungsvariante das Gewebe der Faserschicht ein Glasfilamentgewebe ist. Es kann damit die strukturelle Festigkeit des Einbettfolienmaterials verbessert werden, sodass ein damit ausgerüstetes Photovoltaikelement den Umweltbedingungen besser standhalten kann.

Gemäß einer weiteren Ausführungsvariante kann vorgesehen sein, dass das untere Einbettfolienmaterial gleich ausgebildet ist, wie das obere Einbettfolienmaterial. Es kann damit nicht nur die Herstellung des Photovoltaikelementes vereinfacht werden, sondern ist damit das Photovoltaikelement besser als Bifacial-Photovoltaikelement einsetzbar, da damit die Rückseite des Photovoltaikelementes eine relativ hohe Durchlässigkeit für Sonnenlicht aufweist, das von unterhalb des Photovoltaikelementes sich befindenden Oberflächen reflektiert wird.

Zum besseren Verständnis der Erfindung wird diese anhand der nachfolgenden Figur näher erläutert.

Es zeigt teilweise in vereinfachter, schematischer Darstellung:
- Fig. 1: einen Ausschnitt aus einem Photovoltaikelement im Querschnitt;
- Fig. 2: einen Ausschnitt aus einer Ausführungsvariante des Photovoltaikelements im Querschnitt
- Fig. 3: das Transmissionsspektrum von Einbettfolienmaterialien;
- Fig. 4: das Reflexionsspektrum von Einbettfolienmaterialien.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

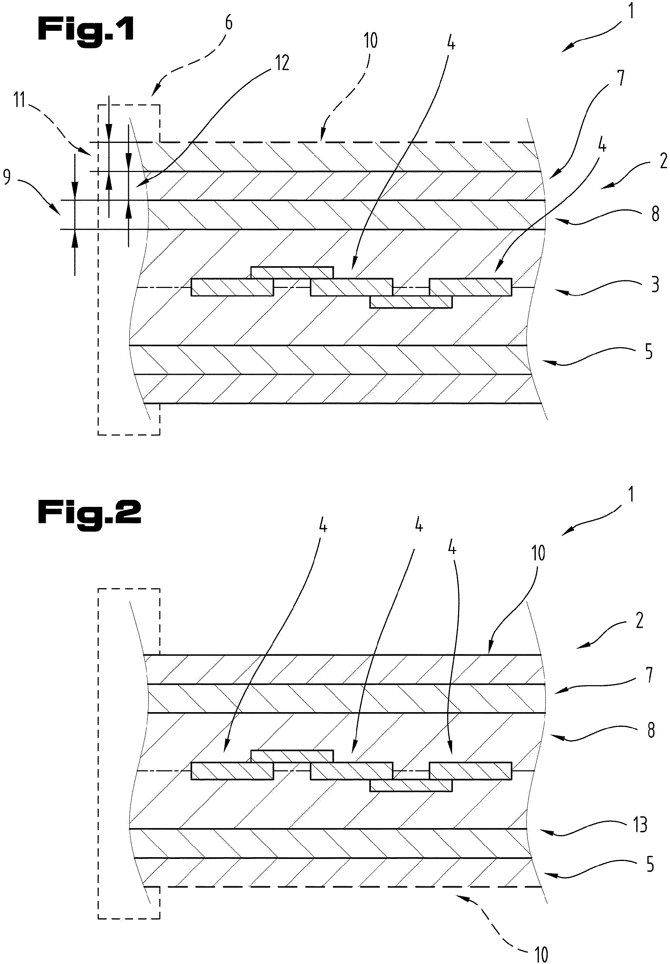

In Fig. 1 ist ein Ausschnitt aus einer ersten Ausführungsvariante eines Photovoltaikelements 1 im Querschnitt dargestellt.

Dieses Photovoltaikelement 1 umfasst ein oberes Einbettfolienmaterial 2, eine darunter angeordnete und mit dem oberen Einbettfolienmaterial 2 verbundene Photovoltaikschicht 3, in dem mehrere Photovoltaikzellen 4 enthalten bzw. eingebettet sind, und ein unteres Einbettfolienmaterial 5, das mit der Photovoltaikschicht 3 verbunden und unterhalb von diesem angeordnet ist, bzw. besteht aus diesen Bestandteilen. Eingefasst kann dieser Schichtaufbau von einem Rahmen 6 werden, der vorzugsweise das obere Einbettfolienmaterial 2 und das untere Einbettfolienmaterial 5 überdeckend angeordnet ist.

Die Photovoltaikzellen 4 und deren in Fig. 1 nur andeutungsweise dargestellte elektrische Kontaktierung bzw. Verdrahtung sind in einem Kunststoff eingebettet, der zusammen mit den Photovoltaikzellen die Photovoltaikschicht 3 bildet.

Der Kunststoff der Photovoltaikschicht 3 kann ein physikalisch vernetzter Kunststoff sein, sodass dieser frei ist von Vernetzungsmitteln oder Spaltprodukten davon. Beispielsweise kann der Kunststoff ein Ionomer sein. Es kann aber auch ein Vinyl-Copolymer, wie z.B. Polyvinylbutyral, oder ein thermoplastisches Elastomer, etc., eingesetzt werden. Das Ionomer kann ausgewählt sein aus einer Gruppe umfassend bzw. bestehend aus ionomeren (Co)polymeren aus Ethylen und einer α,β-ungesättigten Carbonsäure oder einem Carbonsäureanhydrid dieser Carbonsäure, insbesondere (Co)polymeren von Ethylen und Methacrylsäure.

Die physikalische Vernetzung kann über ionische Bindungen im Ionomer erfolgen, wobei Zn2+ oder Ca2+ oder Mg2+ oder Na+ oder K+ oder andere Metallionen als Kation und Carboxylgruppen des Kunststoffes als Anion wirken.

Es sei jedoch darauf hingewiesen, dass prinzipiell auch Polymere eingesetzt werden können, die sich durch entsprechende Anregung erweichen lassen und durch die Erwärmung oder nach anschließender Abkühlung dreidimensional vernetzen.

Der Kunststoff der Photovoltaikschicht 3 kann zur Herstellung des Photovoltaikelementes 1 als ein- oder mehrschichtige Folie eingesetzt werden.

Bevorzugt werden solche Polymere, deren Anregung thermisch möglich ist, da sich dann die physikalische Vernetzung besser in einen Laminationsprozess zur Herstellung des Photovoltaikelementes 1 einbinden lässt.

Bezüglich des Laminationsverfahrens an sich sei auf den einschlägigen Stand der Technik verwiesen.

Bezüglich weiterer Details zu den Photovoltaikzellen 4 sei auf den einschlägigen Stand der Technik verwiesen.

Das obere Einbettfolienmaterial 2 ist durch ein Verbundmaterial, insbesondere eine Verbundfolie, gebildet, die zumindest eine Kunststoffschicht 7 und zumindest eine Faserschicht 8 umfasst oder daraus gebildet ist.

Die Faserschicht 8 ist als eigene Schicht ausgebildet, die zwischen der Kunststoffschicht 7 und den Photovoltaikzellen 4 angeordnet ist, wobei in der Ausführungsvariante des Photovoltaikelementes 1 nach Fig.1 zwischen der Faserschicht 8 und den Photovoltaikzellen 4 noch der Kunststoff der Photovoltaikschicht 3, in den die Photovoltaikzellen 4 eingebettet sind, angeordnet ist. Sollten in der Faserschicht 8 Hohlräume ausgebildet sein, werden diese zu zumindest 50 %, insbesondere zu zumindest 70 %, jeweils bezogen auf das gesamte Hohlraumvolumen, nicht mit dem Kunststoff der Kunststoffschicht 7 und/oder dem Kunststoff der der Photovoltaikschicht 3 ausgefüllt. Die Faserschicht 8 weist einen Anteil an dem Kunststoff der Kunststoffschicht 7 von maximal 10 Gew.-%, insbesondere maximal 8 Gew.-%, bevorzugt maximal 6,5 Gew.-%, auf. Insbesondere kann die Faserschicht 8 vollkommen frei von dem Kunststoff der Kunststoffschicht 7 sein. Zudem kann die Faserschicht 8 in der Ausführungsvariante mit in den Kunststoff der Photovoltaikschicht 3 eingebetteten Photovoltaikzellen 4 einen Anteil an diesem Kunststoff der Photovoltaikschicht 3 von maximal 10 Gew.-% insbesondere maximal 8 Gew.-%, bevorzugt maximal 6,5 Gew.-%, aufweisen.

Gemäß einer Ausführungsvariante des Photovoltaikelementes 1 kann vorgesehen sein, dass der Kunststoff der Kunststoffschicht 7 bis zu einer Dicke der Faserschicht 8 enthalten ist, die maximal 20 %, insbesondere maximale 15 %, vorzugsweise maximal 10 %, der Gesamtdicke 9 der Faserschicht 8 beträgt.

In der Ausführungsvariante des Photovoltaikelementes 1 mit in den Kunststoff der Photovoltaikschicht 3 eingebetteten Photovoltaikzellen 4 kann der Kunststoff der Photovoltaikschicht 3 bis zu einer Dicke der Faserschicht 8 enthalten sein, die maximal 20 %, insbesondere maximale 15 %, vorzugsweise maximal 10 %, der Gesamtdicke 9 der Faserschicht 8 beträgt.

Dabei wird die Dicke der Teilschicht mit dem Kunststoff der Kunststoffschicht 7 bzw. dem Kunststoff der Photovoltaikschicht 3 von der jeweils zugehörigen Oberfläche der Faserschicht 8 aus gemessen.

Die Faserschicht 8 ist aus transparenten Fasern und/oder Fäden gebildet bzw. besteht daraus. Die Fasern und/oder Fäden können ausgewählt sein aus einer Gruppe umfassend oder bestehend aus Glasfasern, organische Fasen, insbesondere Polymerfasern, und Kombinationen daraus.

Bevorzugt werden ausschließlich Glasfasern für die Faserschicht 8 eingesetzt.

Die Fasern und/oder Fäden können in der Faserschicht 8 als Gelege, beispielsweise als Vlies, vorliegen. Bevorzugt wird jedoch ein Gewebe oder ein Gestrick aus den Fasern und/oder Fäden eingesetzt, insbesondere gemäß einer Ausführungsvariante des Photovoltaikelementes 1 ein Glasfilamentgewebe.

Bei Verwendung eines Gewebes sind unterschiedliche Bindungsarten, insbesondere Leinwand-, Köper- oder Atlasbindung, möglich. Bevorzugt wird eine Leinwandbindung eingesetzt.

Das Flächengewicht der Faserschicht 8 kann zwischen 10 g/m² und 1000 g/m² betragen. Bevorzugt wird gemäß einer Ausführungsvariante des Photovoltaikelementes 1 aus voranstehenden Gründen eine Faserschicht 8 mit einem Flächengewicht zwischen 100 g/m² und 150 g/m² eingesetzt. Es kann damit eine geschlossene Schicht erzeugt werden, welche eine einheitliche Materialanbindung an den Kunststoff des Kunststoffschicht 7 ermöglicht. Zudem können damit Eigenschaften des Verbundmaterials, wie Wärmeausdehnung oder Kriechneigung, beeinflusst werden.

Es ist aber auch möglich, ein offenmaschiges Glasgewebe oder Glasgelege mit einem Flächengewischt zwischen 10 g/m² bis 90 g/m² zu verwenden, wenngleich dies nicht die bevorzugte Ausführungsvariante des Photovoltaikelementes 1 ist.

Die Faserschicht 8 kann als Einzelschicht ausgebildet sein. Es ist aber auch möglich, dass die Faserschicht 8 mehrere Einzelschichten aufweist, beispielsweise zwei oder drei, wobei zumindest einzelne der mehreren Einzelschichten zumindest bereichsweise, vorzugsweise zur Gänze, auch aus zum Rest der Einzelschichten unterschiedlichen Fasern und/oder Fäden bestehen können.

Die Kunststoffschicht 7 kann beispielsweise zu zumindest 80 Gew.-%, insbesondere zu zumindest 90 Gew.-%, vorzugsweise zu 100 Gew.-% aus einem (thermoplastischen) Kunststoff bestehen, der ausgewählt ist aus einer Gruppe umfassend oder bestehend aus Polyolefinen, Kunststoffen auf Basis von beispielsweise Polyestern oder Polyamiden. Bevorzugt besteht gemäß einer Ausführungsvariante des Photovoltaikelementes 1 die Kunststoffschicht aus einem Polyethylenterephthalat oder aus einem Ethylen-Tetrafluorethylen-Copolymer.

Es sei an dieser Stelle erwähnt, dass unter einem Kunststoff ein synthetisches oder natürliches Polymer verstanden wird, das aus entsprechenden Monomeren hergestellt ist.

Das Verbundmaterial des oberen Einbettfolienmaterials 2 kann nach einer weiteren Ausführungsvariante des Photovoltaikelementes 1 neben der Faserschicht 8 und der Kunststoffschicht 7 zumindest eine weitere Kunststoffschicht 10 aufweisen (in Fig. 1 strichliert dargestellt), wobei die weitere Kunststoffschicht 10 gegen UV-Strahlenbelastungen stabiler ist, als die an der Faserschicht 8 anliegende Kunststoffschicht 7. Dazu kann diese weitere Kunststoffschicht 10 mit einem UV-Stabilisator versehen sein. Als UV-Stabilisator kann ein in der Kunststoffindustrie üblicherweise verwendeter UV-Stabilisator eingesetzt werden.

Die Kunststoffschicht 10 kann beispielsweise zu zumindest 80 Gew.-%, insbesondere zu zumindest 90 Gew.-%, vorzugsweise zumindest 95 Gew.-%, aus einem (thermoplastischen) Kunststoff bestehen, der ausgewählt ist aus einer Gruppe umfassend oder bestehend aus Polyolefinen, Kunststoffen auf Basis von beispielsweise Polyestern oder Polyamiden. Bevorzugt wird nach einer Ausführungsvariante des Photovoltaikelementes 1 als Kunstsoff für die weitere Kunststoffschicht 10 jedoch das Polymer der an der Faserschicht 8 anliegende Kunststoffschicht 7 verwendet, also insbesondere ein Polyethylenterephthalat oder ein Ethylen-Tetrafluorethylen-Copolymer. Damit ist gemeint, dass das Polymer die gleichen Monomereinheiten aufweist. Allerdings können die Kunststoffe unterschiedliche Eigenschaften aufweisen, die aus unterschiedlichen Polymerisationsgraden resultieren.

Nach einer weiteren Ausführungsvariante des Photovoltaikelementes 1 dazu kann vorgesehen sein, dass die weitere Kunststoffschicht 10 eine Schichtdicke 11 aufweist, die zwischen 10 % und 50 %, insbesondere zwischen 10 % und 20 %, einer Schichtdicke 12 der darunter angeordneten Kunststoffschicht 7 entspricht.

Die Kunststoffschicht 7 kann eine Schichtdicke 12 aufweisen, die zwischen 10 µm und 300 mm beträgt.

In der Fig. 2 ist eine weitere und gegebenenfalls für sich eigenständige Ausführungsvariante des Photovoltaikelementes 1 gezeigt, wobei wiederum für gleiche Teile gleiche Bezugszeichen bzw. Bauteilbezeichnungen wie in der Fig. 1 verwendet werden. Um unnötige Wiederholungen zu vermeiden, wird dazu auf die detaillierte Beschreibung der Fig. 1 hingewiesen bzw. Bezug genommen.

Das Photovoltaikelement 1 nach Fig. 2 weist ebenfalls das der Sonne zuwendbare obere Einbettfolienmaterial, 2 und das untere Einbettfolienmaterial 5 auf. Das obere Einbettfolienmaterial 2 umfasst die Faserschicht 8, die daran anliegende und mit dieser verbundene Kunststoffschicht 7 sowie die weitere Kunststoffschicht 10. Anders als bei der Ausführungsvariante des Photovoltaikelementes 1 nach Fig. 1 liegt die Faserschicht 8 aber unmittelbar an den Photovoltaikzellen 4 an. Die Photovoltaikzellen 4 sind also bei dieser Ausführungsvariante zumindest auf der dem oberen Einbettfolienmaterial 2 zugewandten Seite nicht in einen Kunststoff der Photovoltaikschicht 3 eingebettet.

Es kann nach einer weiteren Ausführungsvariante dazu vorgesehen sein, dass das untere Einbettfolienmaterial 5 eine Faserschicht 13 aufweist, und dass die Faserschicht 13 direkt an den Photovoltaikzellen 4 anliegt. Hinsichtlich dieser Faserschicht 13 sei auf die voranstehenden Ausführungen zur Faserschicht 8 des oberen Einbettfolienmaterials 2 verwiesen.

Die Photovoltaikschicht 3 kann also keinen Kunststoff aufweisen bzw. kann der Kunststoffschicht aus diesem Kunststoff nur so dünn sein, dass die direkte Anlage der beiden Faserschichten 8, 13 an die Photovoltaikzellen 4 ermöglicht wird, der Kunststoff also insbesondere auf Bereich zwischen den Photovoltaikzellen 4 beschränkt sein. Es ist aber auch möglich, dass nur das obere Einbettfolienmaterial 2 direkt an den Photovoltaikzellen 4 anliegt und zwischen den Photovoltaikzellen 4 und dem unteren Einbettfolienmaterial der voranstehend genannte Kunststoff der Photovoltaikschicht 3 angeordnet ist.

Im Rahmen der Erfindung kann generell das untere Einbettfolienmaterial 5 nach einer Ausführungsvariante des Photovoltaikelementes 1 gleich ausgebildet sein, wie das obere Einbettfolienmaterial 2, wenngleich unter Umständen beim unteren (hinteren) Einbettfolienmaterial 5 auf die weitere, UV-stabilisierte Kunststoffschicht 10 verzichtet werden kann.

Es ist aber auch möglich, dass die Faserschicht 13 des unteren Einbettfolienmaterials 5 ein höheres Flächengewicht und/oder andere Fasern bzw. Fäden aufweist, als die Faserschicht 8 des oberen Einbettfolienmaterials 2, wobei auch bei dieser Ausführungsvariante das Flächengewicht der Faserschicht 13 des unteren Einbettfolienmaterials 5 bevorzugt aus den voranstehend für die Faserschicht 8 genannten Flächengewichtsbereichen ausgewählt ist.

Bei sämtlichen Ausführungsvariante des Photovoltaikelementes 1 kann das Gewebe der Faserschicht 8 und gegebenenfalls der Faserschicht 13 aus Glasfasern bestehen, wobei die Glasfasern aus einem Aluminiumborsilikatglas oder Borsilikatglas bestehen. Insbesondere können die Glasfasern aus einem Glas bestehen, das zumindest für sichtbares Licht (380 nm bis 750 nm) einen Transmissionsgrad von zumindest 50 %, insbesondere zumindest 60 %, aufweist.

Generell kann/können die Schichten des oberen Einbettfolienmaterials 2 und/oder des unteren Einbettfolienmaterials 5 untereinander über einen Klebstoff verbunden werden. Hierzu eignen sich einerseits 2 Komponenten Klebstoffsysteme auf Polyurethanbasis oder auch Heißklebesysteme. Neben Klebstoffen kann auch die Coextrusion und die Extrusionsbeschichtung als Verbindungsmöglichkeit zumindest der beiden Kunststoffschichten 7, 10 miteinander eingesetzt werden. Selbstverständlich ist auch eine Kombination möglich, bei der Kunststoffe coextrudiert und mit einer extrusionsbeschichteten Faserschicht 8, 13 miteinander klebekaschiert werden.

Zur Evaluierung der Werkstoffe wurden verschiedene Tests durchgeführt.

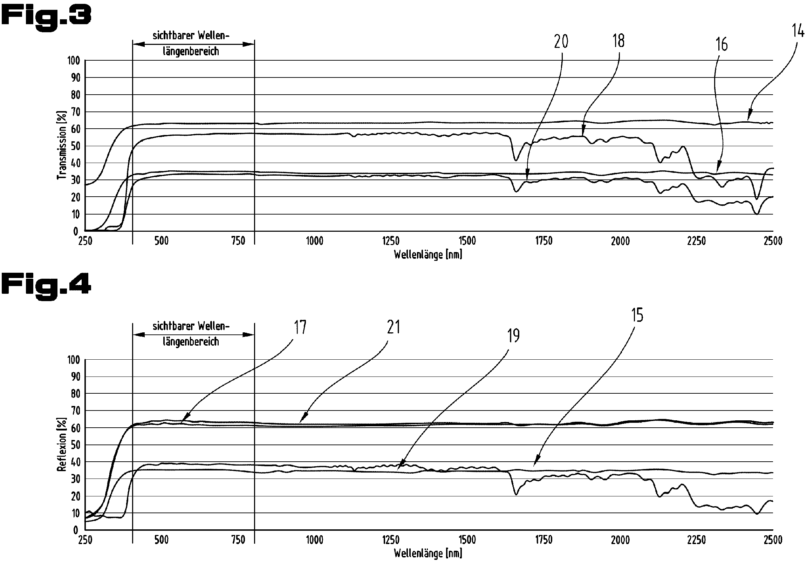

In den Fig. 3 und 4 ist das Transmissionsspektrum bzw. Reflexionsspektrum des oberen Einbettungsfolienmaterials 2 mit dem Aufbau Glasfaser-Faserschicht 8 / PET Kunststoffschicht 7 mit einer Schichtdicke 12 von 250 µm zur elektrischen Isolation / UV stabilisierte PET Kunststoffschicht 10 mit einer Schichtdicke 12 von 19 µm (Wellenlänge auf der Abszisse aufgetragen) dargestellt. Die Verbindung der Schichten erfolgte über einen Pulyurethan basierten Klebstoff, wobei für die Verbindung der Faserschicht 8 mit der PET-Kunststoffschicht 7 in etwa die doppelte Menge Klebstoff verwendet wurde, als für die Verbindung der PET-Kunststoffschicht 7 mit der PET Kunststoffschicht 10. Die Messung erfolgte mittels UV-VIS-NIR-Spektrometer mit 150 mm Ulbricht-Kugel. Die gerichtet-hemisphärischen Transmissions- (T) und Reflexionsgrade (R) wurden im Wellenlängenbereich von 250 nm bis 2500 nm aufgezeichnet. Die Gewichtung der Spektren erfolgte mit dem terrestrischen Solarspektrum AM1,5 im Integrationsbereich von 400 nm bis 1100 nm.

Im für Photovoltaikelemente 1 relevanten Wellenlängenbereich von 400 nm bis 1100 nm weist ein Glasfasergewebe an sich mit einem Flächengewicht von 100 g/m² (obere Kurve 14 in Fig. 3 und untere Kurve 15 in Fig. 4) eine Lichttransmission T von ca. 60 % und eine Lichtreflexion R von ca. 18 % auf, ein Glasfasergewebe an sich mit einem Flächengewicht von 200 g/m² (Kurve 16 in Fig. 3 und untere Kurve 17 in Fig. 4) eine Lichttransmission T von ca. 30 % und eine Lichtreflexion R von ca. 62 % auf. Das obere Einbettfolienmaterial 2 weist bei einem Flächengewicht der Glasfaser Faserschicht 8 von 100 g/m² (Kurve 18 in Fig. 3 und untere Kurve 19 in Fig. 4) eine Lichttransmission T von ca. 50 % - 55 % und eine Lichtreflexion R von ca. 40 % auf. Bei einem Flächengewicht der Glasfaser Faserschicht 8 von 200 g/m² (Kurve 20 in Fig. 3 und untere Kurve 21 in Fig. 4) weist das obere Einbettfolienmaterial 2 eine Lichttransmission T von ca. 30 % und eine Lichtreflexion R von ca. 63 % auf.

Generell kann das Gewebe der Faserschicht 8, 13 ein Flachgewebe sein.

Weiter kann das Gewebe der Faserschicht 8, 13 auch aus einer Mischung aus Fasern oder Fäden aus verschiedenen Werkstoffen bestehen, sodass im Gewebe der Faserschicht 8, 13 gegebenenfalls auch Verstärkungsfasern enthalten sind. Die Verstärkungsfasern sind vorzugsweise ebenfalls transparent. Die Verstärkungsfasern können auch ausgewählt sein aus einer Gruppe umfassend oder bestehend aus Glasfasern, Aramidfasern, Kohlenstofffasern, Mineralfasern, wie beispielsweise Basaltfasern, Naturfasern, wie z.B. Hanf, Sisal, und Kombinationen daraus. Die Verstärkungsfasern können in einem Anteil in der Faserschicht 8, 13 enthalten sein, der ausgewählt ist aus einem Bereich von 2 Gew.-% bis 6 Gew.-%. Die Verstärkungsfasern können in dem Gewebe der Faserschicht 8, 13 mitverwoben sein. Es ist jedoch auch möglich, dass alternativ oder zusätzlich dazu die Kunststoffschicht 7 die Verstärkungsfasern (in dem angegebenen Anteil) enthält.

Sofern das Photovoltaikelement den Rahmen 6 aufweist, kann dieser durch Umformung aus dem Verbundwerkstoff des oberen und/oder unteren Folienmaterials 2, 5 hergestellt und insbesondere einstückig damit ausgebildet sein.

In der bevorzugten Ausführungsvariante weist das Photovoltaikelement 1 oberhalb des oberen Einbettfolienmaterials 2 keine weitere Abdeckung mehr auf, insbesondere keine Glasscheibe.

Weiter ist bei allen Ausführungsvarianten der Erfindung von Vorteil, wenn das Glasfilamentgewebe aus Garnen aus Glasfäden gebildet ist, wobei das Garn für die Kettfäden eine höhere Fadendichte aufweist als für die Schußfäden, insbesondere eine um mindestens 10 % höhere Fadendichte, bezogen auf die Fadendichte der Schußfäden. Das Glasfilamentgewebe bzw. die Faserschicht 8 kann zudem mit einer Silanschlichte oder einer Textilschlichte versehen sein.

Die Ausführungsbeispiele zeigen bzw. beschreiben mögliche Ausführungsvarianten des Photovoltaikelementes 1, wobei an dieser Stelle bemerkt sei, dass auch diverse Kombinationen der einzelnen Ausführungsvarianten untereinander möglich sind.

Der Ordnung halber sei abschließend darauf hingewiesen, dass zum besseren Verständnis des Aufbaus des Photovoltaikelementes 1 dieses bzw. dessen Bestandteile teilweise unmaßstäblich und/oder vergrößert und/oder verkleinert dargestellt wurden.

### Bezugszeichenaufstellung

- 1: Photovoltaikelement
- 2: Einbettfolienmaterial
- 3: Photovoltaikschicht
- 4: Photovoltaikzelle
- 5: Einbettfolienmaterial
- 6: Rahmen
- 7: Kunststoffschicht
- 8: Faserschicht
- 9: Gesamtdicke
- 10: Kunststoffschicht
- 11: Schichtdicke
- 12: Schichtdicke
- 13: Faserschicht
- 14: Kurve
- 15: Kurve
- 16: Kurve
- 17: Kurve
- 18: Kurve
- 19: Kurve
- 20: Kurve
- 21: Kurve

## Patentansprüche

1. Photovoltaikelement (1) umfassend ein oberes Einbettfolienmaterial (2) und ein unteres Einbettfolienmaterial (5), wobei zwischen dem oberen und dem unteren Einbettfolienmaterial (2, 5) Photovoltaikzellen (4) eingebettet sind, und das obere Einbettfolienmaterial (2) durch ein Verbundmaterial gebildet ist, das eine Kunststoffschicht (7) und transparente Fasern umfasst, **dadurch gekennzeichnet, dass** die transparenten Fasern eine eigene Faserschicht (8) bilden, die einen Anteil an dem Kunststoff der Kunststoffschicht (7) von maximal 10 Gew.-% aufweist.

2. Photovoltaikelement (1) nach Anspruch 1, **dadurch gekennzeichnet, dass** der Kunststoff der Kunststoffschicht (7) bis zu einer Dicke der Faserschicht enthalten ist, die maximal 20 % der Gesamtdicke (9) der Faserschicht (8) beträgt.

3. Photovoltaikelement (1) nach Anspruch 1 oder 2, **dadurch gekennzeichnet, dass** die Kunststoffschicht (7) aus einem Polyethylenterephthalat und/oder einem Ethylen-Tetrafluorethylen-Copolymer besteht.

4. Photovoltaikelement (1) nach einem der Ansprüche 1 bis 3, **dadurch gekennzeichnet, dass** auf der, der Faserschicht (8) abgewandten Seite der Kunststoffschicht (7) eine weitere Kunststoffschicht (10) angeordnet ist, die gegen UV-Strahlen stabiler ist, als die darunter angeordnete Kunststoffschicht (7).

5. Photovoltaikelement (1) nach Anspruch 4, **dadurch gekennzeichnet, dass** die weitere Kunststoffschicht (10) das Polymer der darunter angeordneten Kunststoffschicht (7) aufweist.

6. Photovoltaikelement (1) nach Anspruch 4 oder 5, **dadurch gekennzeichnet, dass** die weitere Kunststoffschicht (10) eine Schichtdicke (11) aufweist, die zwischen 10 % und 50 % einer Schichtdicke (12) der darunter angeordneten Kunststoffschicht (7) entspricht.

7. Photovoltaikelement (1) nach einem der Ansprüche 1 bis 6, **dadurch gekennzeichnet, dass** die Faserschicht (8) direkt an den Photovoltaikzellen (4) anliegt.

8. Photovoltaikelement (1) nach einem der Ansprüche 1 bis 7, **dadurch gekennzeichnet, dass** die Faserschicht (8) ein Flächengewicht von mindestens 100 g/m² und maximal 150 g/m² aufweist.

9. Photovoltaikelement (1) nach einem der Ansprüche 1 bis 8, **dadurch gekennzeichnet, dass** die Faserschicht (8) ein Glasfilamentgewebe ist.

10. Photovoltaikelement (1) nach einem der Ansprüche 1 bis 9, **dadurch gekennzeichnet, dass** das untere Einbettfolienmaterial (5) gleich ausgebildet ist, wie das obere Einbettfolienmaterial (2).
